# EUROPÄISCHE PATENTSCHRIFT

(11) **EP 0 633 585 B1**
(45) Veröffentlichungstag und Bekanntmachung des Hinweises auf die Patenterteilung: **05.11.1997**
(21) Anmeldenummer: 94201946.4
(22) Anmeldetag: 06.07.1994
(51) Int. Cl.: H01H 13/70, H04M 1/02, H05K 9/00

(54) **Gehäuse für Geräte der elektrischen Nachrichtentechnik**
Housing for electric communication apparatus
Boîtier pour appareils de télécommunication électrique

(30) Priorität: 08.07.1993 DE 4322753; 21.09.1993 DE 4332023; 21.01.1994 DE 4401683
(43) Veröffentlichungstag der Anmeldung: 11.01.1995
(73) Patentinhaber: Philips Patentverwaltung GmbH, 22335 Hamburg (DE); PHILIPS ELECTRONICS N.V., 5621 BA Eindhoven (NL)
(72) Erfinder: Rademacher, Karl-Heinz c/o Philips Pat.-verw. GmbH, D-22335 Hamburg (DE); Althaus, Jens-Peter c/o Philips Patentverw. GmbH, D-22335 Hamburg (DE)
(74) Vertreter: Erdmann, Anton, Dipl.-Ing.

(56) Entgegenhaltungen:
- EP-A- 0 393 236
- DE-A- 3 429 353
- DE-A- 3 736 892
- DE-A- 3 838 901
- DE-U- 8 710 740
- DE-U- 9 012 155
- US-A- 4 638 151
- NEW ELECTRONICS.INCORPORATING ELECTRONICS TODAY, Bd.18, Nr.3, Februar 1985, LONDON GB Seiten 56 - 60 TERRY MCINTYRE 'Membrane Keyboards provide low-cost solution'

## Beschreibung

Die Erfindung bezieht sich auf ein Gehäuse für Geräte der elektrischen Nachrichtentechnik, z.B. Telefongehäuse, und auf ein Verfahren zur Herstellung derartiger Gehäuse.

Durch das DE-GM 92 01 594 ist ein Gehäuse der eingangs genannten Art bekannt geworden, das aus zwei Kunststoffschalen besteht, die innenseitig mit einer metallischen Abschirmung versehen sind. Die metallische Abschirmung kann z.B. durch Bedampfen oder durch Galvanisieren aufgebracht werden.

Für erhöhte EMV-Anforderungen werden Metallschichten an den Innenseiten der Gehäuse benötigt, deren Dicke etwa 20 µm bis 40 µm beträgt. Diese Schichtstärken lassen sich durch eine Aluminium-Vakuumbedampfung nicht mehr sicher mit gleicher Schichtstärke an allen Gehäusestellen produzieren. Galvanische Schichten erfordern eine zusätzliche Oberflächenbehandlung, um die Designanforderungen zu erfüllen (Lack). Weiterhin ist die Umweltverträglichkeit sehr kritisch und ein Recycling fast unmöglich.

Aus der DE-A-3838901 ist ein Kunststoffgehäuse bekannt, das aus einem offenporigen Metallinlett besteht, das von einer Kunststoffschicht durchdrungen und allseitig umschlossen ist.

Durch die DE-OS 34 29 353 ist ein Plastrahmen für Gerätegehäuse und Bauteile, insbesondere für mechanische und elektromotorische Geräte, mit Teilelementen aus Nicht-Plaste bekannt geworden. Dabei ist vorgesehen, daß ebene oder vorgeformte Flächenelemente eines Bauteils aus Nicht-Plaste in ein Spritzgießwerkzeug lagebestimmt eingelegt und in einem an sich bekannten Arbeitsgang durch thermoplastischen Werkstoff verbunden werden. Im Spritzgießwerkzeug werden dabei die Ränder der nicht plastischen Teile mit Thermoplast umspritzt und miteinander verbunden. Dabei umfaßt der thermoplastische Werkstoff ein- oder zweiseitig die jeweiligen Zuschnittkanten klauenartig. Notwendige Funktionselemente, z.B. stabilisierende Rippen oder Augen für Auflagen und Schraubverbindungen, können durch thermoplastischen Werkstoff im gleichen Arbeitsgang mit angeformt werden. Die nicht plastischen Einlegeteile flächiger Art werden in herkömmlicher Weise als ebene Zuschnitte oder als vorgeformte Bauteile so hergestellt, daß auch notwendige Durchbrüche, Ausnehmungen oder dergl. realisiert werden können.

Durch die DE-AS 14 04 394 ist ein Verfahren zur Herstellung einer Wanne aus mehreren Lagen Kunststoff bekannt geworden. Dabei wird zunächst als Innenschicht der Wanne eine verhältnismäßig dünne Platte aus thermoplastischem Material im Tiefziehverfahren zur Wanne verformt, und danach werden entsprechend den statischen Erfordernissen auf die verformte Innenschicht außen mehrere Schichten faserverstärkter härtbarer Polymerisationsharze aufgebracht und gehärtet.

Der Erfindung liegt die Aufgabe zugrunde, Gehäuse der eingangs genannten Art im Hinblick auf verschärfte Anforderungen für die Störsicherheit zu verbessern.

Diese Aufgabe wird gemäß der Erfindung bei Gehäusen der eingangs genannten Art gelöst durch ein innenseitiges Blechformteil, das mit einer die Gehäuseaußenhaut bildenden Thermoplastschicht fest verbunden ist. Die Verbindung erfolgt z.B. durch Haftung an der Oberfläche oder durch Verknüpfen mit weiter unten beschriebenen Spritzgußelementen. Ein derartig aufgebautes Gehäuse besitzt eine stabile, metallische Innenschale. Damit können die erforderlichen Dicken der innenseitigen Metallbeschichtung problemlos gelöst werden. Überdies können derartige Blechformteile dazu dienen, eine bessere Wärmeverteilung bzw. Wärmeabfuhr zu ermöglichen. Außerdem ist eine derartige Bauweise günstig im Hinblick auf eine einfache Entsorgung.

In Ausgestaltung der Erfindung beträgt die Dicke des Blechformteiles z.B. ca. 0,2 mm bis 0,3 mm. Derartige Blechformteile ermöglichen eine sehr gute Wärmeabfuhr und Stabilität für den Spritzgußprozeß.

In Ausgestaltung der Erfindung sind das vorgeprägte Blechformteil und die aus Thermoplast gebildete Gehäuseaußenhaut durch Umspritzen an Kanten oder dergl. miteinander fest verbunden. Diese Bauweise ermöglicht eine innige und zuverlässige Verbindung des Blechformteiles mit der Gehäuseaußenwand, die noch dadurch verbessert werden kann, daß das Blechformteil und die Gehäuseaußenwand zusätzlich noch durch besondere Befestigungselemente miteinander verbunden sind.

Ein einfaches und leicht durchführbares Verfahren zur Herstellung eines Gehäuses der eingangs genannten Art ist durch folgende Schritte gekennzeichnet:
a) das Blechformteil wird in einem Tiefziehwerkzeug entsprechend der gewünschten Form geprägt,
b) das so vorgefertigte Blechformteil wird in ein Spritzgußwerkzeug eingelegt, das entsprechend der gewünschten Außenkontur des Gehäuses ausgebildet ist,
c) das eingelegte Blechformteil wird, unter Freilassung von auf dem Blechformteil vorgesehenen Durchbrüchen, entsprechend der gewünschten Außenkontur des Gehäuses mit einem Thermoplast umspritzt.

Dabei werden die Durchbrüche entsprechend den EMV-Anforderungen bereits bei der Vorfertigung des Blechformteiles im Tiefziehwerkzeug angebracht. Das Spritzgußwerkzeug ist entsprechend der gewünschten Außenform des Gehäuses ausgebildet.

Je nach der gewünschten Außenform des Gehäuses kann das Spritzgußwerkzeug entsprechend geändert werden. Ein neues bzw. anderes Spritzgußwerkzeug erstellt leicht ein neues Design bei gleicher Innenschale.

In Ausgestaltung der Erfindung ist vorgesehen, daß das Blechformteil vor dem Umspritzen an der Innenseite des Gehäuses im Bereich von Aussparungen mit Funktionselementen versehen wird und daß die Funktionselemente beim Spritzgießvorgang durch das durch die Aussparungen durchtretende Spritzgut mit der Gehäuseaußenhaut verbunden werden. Auf diese Weise können notwendige Funktionselemente ohne besondere Befestigungselemente an der Innenseite des Gehäuses befestigt werden.

Eine weitere Ausgestaltung der Erfindung besteht darin, daß das Blechformteil mit zusätzlichen Öffnungen versehen wird und daß das beim Spritzgießvorgang durch diese Öffnungen durchtretende Spritzgut zusätzliche Verbindungselemente zwischen dem Blechformteil und der Außenhaut bildet. Damit kann auf einfache Weise die Verbindung zwischen dem Blechformteil und der Gehäuseaußenhaut verbessert werden.

Durch die DE-A-37 36 116 ist eine Tastenkappe für eine Tastatur bekannt geworden. Diese Tastenkappe ist an einem Rahmen geführt, deckt ein Schaltelement und ein Leuchtelement ab und weist für das Schaltelement einen Bedienbereich und vor dem Leuchtelement eine durchscheinende Symbolzone auf. Die Tastenkappe besteht aus einer flexiblen, durchscheinenden Folie in flacher Form, die mit einem Randbereich an dem Rahmen festgelegt ist. Als Bedienbereich ist an die Folie im Abstand vom Randbereich ein Körper angespritzt. Die Folie bildet zwischen dem Randbereich und dem Körper einen Gelenkbereich, wobei zwischen dem Körper und dem Gelenkbereich die bedruckte Symbolzone vorgesehen ist.

Durch die DE-A-36 30 898 ist ein Bedien- und Anzeigefeld eines elektronischen Gerätes bekannt geworden, das eine durchsichtige, flexible Deckfolie aus Polyester aufweist. Bei dieser Bauart geht es darum, Durchsichtigkeit, Bedruckung, Oberflächenerscheinung und Bedienfunktion zu integrieren. Dies wird dadurch erreicht, daß neben durchsichtigen Bereichen des Bedien- und Anzeigefeldes auf die Deckfolie, auf deren der Sichtseite gegenüberliegenden Unterseite, eine Haftvermittlerschicht aus einem auf Polyester haftenden Klarlack aufgedruck ist, und daß auf den Klarlack eine eine Bürststruktur aufweisende Metallschicht aufgebracht ist.

Durch die EP-A-0 500 330 ist ein flacher Einbauschalter mit einer eingebauten Beleuchtung bekannt geworden. Dieser Schalter enthält drei auf einer Leiterplatte angeordnete Festkontakte, die von einer federnden, halbkugelförmigen Membran betätigt werden können. Zum Schutz wird dieser Schalter von einer isolierenden Kunststoffhaut überspannt.

Eine weitere Ausgestaltung der Erfindung besteht darin, daß das Blechformteil im Bereich der Tasten bewegbare Zungen aufweist, die über mindestens einen federnden Steg einseitig mit dem Blechformteil verbunden und von der Thermoplastschicht überzogen sind. Damit erstreckt sich die die Außenhaut bildende Thermoplastschicht, unter Freilassung der eine Bewegung der Zungen behindernden Bereiche, auch über die Zungen selbst. Somit kann eine Eingabetastatur ohne zusätzliche Einzelteile und Montagevorgänge erstellt werden. Das in einem ersten Arbeitsgang hergestellte Blechformteil enthält somit nunmehr auch die als Grundlage für die Tasten dienenden federnden Zungen, die gleichzeitig mit der Herstellung des Blechformteiles in einem Arbeitsgang gebildet werden. Als Grundmaterial werden nur Metall und Kunststoff verwendet. Damit ergibt sich eine recyclinggerechte Lösung, da Metall und Kunststoff sich nicht gegenseitig verunreinigen und damit trennbar bleiben. Außerdem unterstützt die die Eingabetastatur bildende Blechmatrix die Entwärmung, d.h. die Wärmeverteilung, des Gerätes.

Die Zungen werden in Ausgestaltung der Erfindung jeweils durch einen halbkreisförmigen Spalt im Blechformteil gebildet und sind dadurch jeweils über einen federnden Steg mit dem Blechformteil verbunden. In einer weiteren Ausgestaltung der Erfindung ist zwischen den Enden der halbkreisförmigen Spalte jeweils ein weiterer Spalt vorgesehen. Dies führt dazu, daß jede Zunge über zwei federnde Stege mit dem Blechformteil verbunden ist. In beiden Fällen kann sich die Thermoplastschicht soweit in den Bereich der federnden Stege erstrecken, daß eine Bewegung der Zungen nicht behindert wird.

In Ausgestaltung der Erfindung ist vorgesehen, daß das Blechformteil im Bereich der Zungen mit Öffnungen versehen ist. Diese Öffnungen können dazu dienen, die Haftung zwischen dem Thermoplastwerkstoff und den Zungen zu verbessern, indem Werkstoff durch die Öffnungen hindurchtritt und auf der Gegenseite einen Widerhalt bildet.

Eine andere Ausgestaltung der Erfindung besteht darin, daß die Zungen jeweils mit einer Mittenöffnung versehen sind und daß die Thermoplastschicht im Bereich der Mittenöffnungen aus durchscheinendem Werkstoff besteht. Damit wird eine einfache Möglichkeit geschaffen, die durch die Zungen und den Werkstoff gebildeten Tasten zu beleuchten, indem unterhalb der Tasten eine Lichtquelle angeordnet ist, die den Werkstoff durchscheint.

Eine andere Ausgestaltung der Erfindung ist gekennzeichneet durch eine Zweifarben-Spritzgießtechnik mit dunklem Werkstoff im Randbereich der Zungen und mit durchscheinendem Werkstoff im Bereich der mit den Mittenöffnungen versehenen Zungen.

Bei erhöhten Schutz- oder Designanforderungen ist gemäß einer weiteren Ausgestaltung der Erfindung vorgesehen, daß die vom Thermoplast freien Zwischenräume zwischen den Tasten von einer Abdeckplatte verschlossen bzw. abgedeckt sind. Diese Abdeckplatte kann entweder aus dem gleichen Thermoplastwerkstoff bestehen, aus dem die Außenhaut gefertigt ist, oder aber in weiterer Ausgestaltung der Erfindung aus Metall gefertigt sein. Damit wird der Tastenraum weitgehend gegen elektromagnetische Störungen abgedeckt.

Für die vollständige Tastaturfunktion wird der somit gebildete integrierte Tastensatz zusammen mit der Gehäuseschale über einer Schalteranordnung, Schalterfolie oder Schnappscheiben-Anordnung montiert. Als Tastenbeleuchtung können Lumineszenzdioden oder andere Lichtquellen verwendet werden.

Bei der Herstellung eines Gehäuses ist dabei vorgesehen, daß das Blechformteil im Tastenbereich mit federnden Zungen versehen wird, die gleichzeitig mit dem Blechformteil mit Thermoplast umspritzt werden. Dabei können die über mindestens einen federnden Steg mit dem Blechformteil verbundenen Zungen vorzugsweise durch randseitige Ausstanzungen gebildet werden.

Durch die JP 4-116899 (A) ist eine Anordnung zur Abschirmung der Innenseite eines Gehäuses bekannt geworden. Dabei enthält das Gehäuse einen metallischen Kern mit beidseitig angeordneten, hochfrequenten Schaltkreisen. Auf die vier Seiten des Kernes ist eine U-förmige Feder aufgesetzt mit einer nach außen gerichteten Zunge. Beim Zusammenbau des zweischaligen Gehäuses gerät die Zunge in Kontakt mit einem auf der Innenseite des Gehäuses aufgebrachten Aluminiumfilm, so daß zwei im Gehäuse gebildete Kammern vollständig abgeschirmt werden können.

Eine weitere Ausgestaltung der Erfindung besteht darin, daß die einander überlappenden Enden der beiden Blechformteile einen im Querschnitt schwalbenschwanzförmigen Vorsprung bilden und durch mindestens ein den Vorsprung übergreifendes Schließelemenet zusammengehalten werden. Eine derartige Bauweise mit mindestens einem gemeinsamen Schließelement für beide Blechformteile ermöglicht ein sicheres Schließen der beiden Gehäuseschalen im Bereich der Fügekante, so daß eine zuverlässige HF-Dichtung zwischen den beiden Gehäuseschalen erreicht werden kann. Diese Bauweise kann noch dadurch verbessert werden, daß in Ausgestaltung der Erfindung das Schließelement elektrisch leitend ausgeführt wird. Eine weitere Verbesserung ist dadurch zu erreichen, daß das Schließelement mit hinterschnittenen Nuten versehen und/oder federnd ausgebildet ist. Eine derartige Ausgestaltung ermöglicht eine einfache Montage des Schließelementes.

In einer weiteren Ausgestaltung der Erfindung ist vorgesehen, daß ein einziges, U-förmiges Schließelement verwendet wird, das in montiertem Zustand eine Stirnkante und mindestens Teile der beiden Seitenkanten des Gehäuses umfaßt. Nach dem Zusammenfügen der beiden Gehäuseschalen kann somit ein derartig gestaltes, U-förmiges Schließelement von einer Stirnseite her aufgeschoben werden, so daß eine einfache, schnelle und zuverlässige HF-dichte Verbindung beider Gehäuseschalen ermöglicht wird.

In weiterer Ausgestaltung der Erfindung ist vorgesehen, daß bei einem Gehäuse mit einem abgesetzten Bereich zur Aufnahme eines Akkus dieser entsprechend gestaltete schwalbenschwanzförmige Vorsprünge aufweist und daß die Seitenteile des U-förmigen Schließelementes sich über die gesamte Länge des Gehäuses erstrecken. Damit wird gewährleistet, daß auch bei einem derart gestalteten Gehäuse mit einem abgesetzten Raum zur Aufnahme eines Akkus eine zuverlässige Verbindung beider Gehäuseschalen gewährleistet ist.

Die Störstrahlsicherheit eines eingangs genannten Gehäuses kann ferner dadurch verbessert werden, daß das Blechformteil im Bereich der Tastatur als geschlossene Fläche ausgebildet ist, auf welcher eine Tastaturschaltfolie aufgebracht ist, deren elektrische Verbindungen durch eine einzige Öffnung in das Gehäuse geführt sind. Bei dieser Bauart eines Gehäuses werden in der Oberschale somit keine Durchbrüche für das Tastenfeld benötigt. Es genügt lediglich ein Durchbruch zum Durchführen der von der Tastaturschaltfolie kommenden elektrischen Leitungen, die zu Bauteilen innerhalb des Gehäuses geführt werden. Eine derartige Tastaturschaltfolie kann z.B. durch Kleben auf der Oberfläche des Blechformteiles befestigt werden, die dazu z.B. eine eingelassene Mulde aufweist.

Wenn die Wärmeabfuhr bei derartig aufgebauten Gehäusen mit Blechformteilen nicht ausreicht, kann eine gezielte Wärmeabfuhr dadurch ermöglicht werden, daß partielle Aussparungen in der die Außenhaut bildenden Thermoplastschicht angeordnet sind. Diese können z.B. in Form von Schlitzen in einem Bereich gegenüber der Hörermuschel angeordnet sein.

In der Zeichnung sind in den Fig. 1 bis 19 Ausführungsbeispiele des Gegenstandes gemäß der Erfindung schematisch dargestellt.
Fig. 1 zeigt eine geschnittene, perspektivische Darstellung einer Gehäuseschale eines Fernsprechgerätes,
Fig. 2 zeigt in einem vergrößerten perspektivischen Teilquerschnitt die Verbindung einer oberen Gehäuseschale gemäß Fig. 1 mit einer unteren Gehäuseschale,
Fig. 3 zeigt in einem Teilquerschnitt eine andere Art der Verbindung von zwei Gehäusehälften,
Fig. 4 zeigt eine Seitenansicht eines Tiefziehwerkzeuges,
Fig. 5 zeigt eine Seitenansicht einer Spritzgußform,
Fig. 6 und 7 zeigen jeweils in einem Ausschnitt eine Draufsicht auf ein vorgefertigtes Blechformteil im Bereich von Tasten eines nicht dargestellten Gehäuses,
Fig. 8 und 9 zeigen zugehörige Schnittdarstellungen mit zusätzlich aufgespritztem Kunststoff im Bereich der Tasten,
Fig. 10 und 11 zeigen jeweils in einem Ausschnitt Draufsichten auf Abdeckbleche im Tastenbereich,
Fig. 12 und 13 zeigen entsprechende Schnittdarstellungen zu Fig. 10 und 11 mit zusätzlich aufgespritztem Kunststoff,
Fig. 14 und 15 zeigen jeweils in einem Teilquerschnitt einen integrierten Tastensatz gemäß der Erfindung zusammen mit einer Gehäuseschale über einer Schalteranordnung,
Fig. 16 zeigt eine Seitenansicht eines Hand-Telefons im Schnitt,
Fig. 17 zeigt eine Draufsicht gemäß Fig. 16,
Fig. 18 zeigt eine vergrößerte Schnittdarstellung des rechten Stirnbereiches in Fig. 16, und
Fig. 19 zeigt eine perspektivische Darstellung eines Hand-Telefons mit einer aufzubringenden Tastaturschaltfolie.

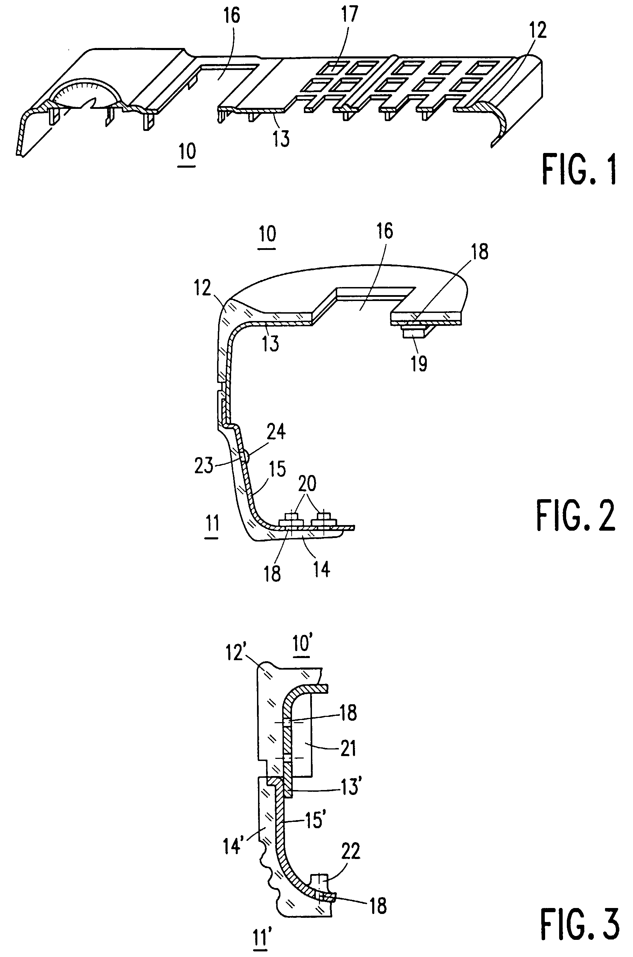

Fig. 1 zeigt eine obere Gehäuseschale 10, die gemäß Fig. 2 mit einer unteren Gehäuseschale 11 zu einem vollständigen Gehäuse zusammengesetzt wird. Die obere Gehäuseschale 10 besitzt eine aus Thermoplast bestehende Gehäuseaußenhaut 12 und ein innenliegendes Blechformteil 13, und die untere Gehäuseschale 11 besitzt eine außenliegende, aus Thermoplast bestehende Gehäuseaußenhaut 14 und ein innenliegendes Blechformteil 15. Die Gehäuseaußenhaut 12 bzw. 14 wurde in einem Spritzgußverfahren jeweils auf das vorgeprägte Blechformteil 13, 15 aufgespritzt. Mit 16, 17 sind betriebsmäßig vorgesehene Durchbrüche bezeichnet.

Fig. 3 zeigt eine andere Verbindungstechnik zwischen zwei Gehäuseschalen 10', 11' im Bereich der Stoßfugen. Die Blechformteile sind dabei mit 13' bzw. 15' bezeichnet.

Die Blechformteile 13, 15 und 13', 15' gemäß Fig. 2 und 3 besitzen außer den genannten Durchbrüchen 16, 17 weitere Aussparungen 18. Im Bereich dieser Aussparungen 18 befinden sich Funktionselemente 19 bis 22, die beim Spritzgießvorgang an der Innenseite des Gehäuses befestigt werden, indem flüssiges Thermoplastmaterial durch die Öffnungen 18 hindurchtritt und die Funktionselemente 19 bis 22 festlegt. Auf ähnliche Weise kann durch weitere Öffnungen 23 beim Spritzgußvorgang Material hindurchtreten, welches Befestigungselemente 24 zur Verbindung der Außenhaut 12, 14 mit dem Blechformteil 13, 15 bildet.

Somit ist es möglich, in einem einzigen Spritzgußprozeß z.B. das komplette Gehäuse gemäß Fig. 2 mit Außenhaut 12, 14, Blechformteilen 13, 15 und Funktionselementen 19, 20 herzustellen.

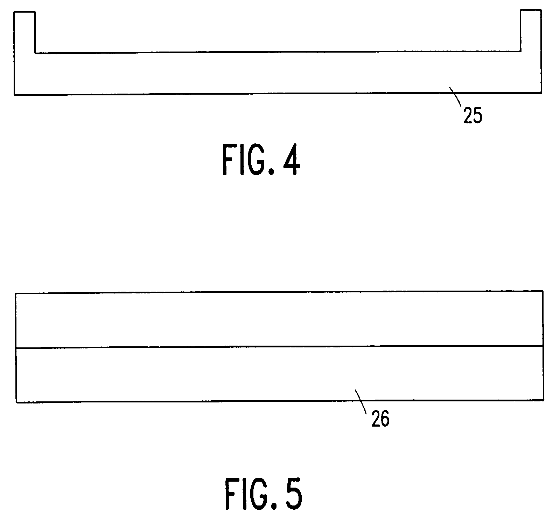

Fig. 4 zeigt die schematische Seitenansicht eines Tiefziehwerkzeuges 25 zur Prägung eines Blechformteiles 13, 15.

Fig. 5 zeigt die schematische Seitenansicht einer zweiteiligen Spritzgußform 26, in welcher die eingelegten, vorgefertigten Blechformteile 13, 14 umspritzt werden.

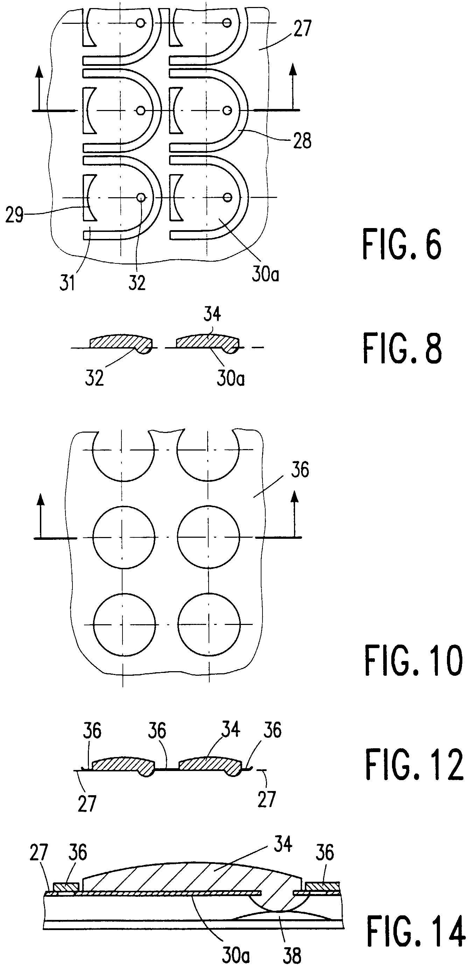

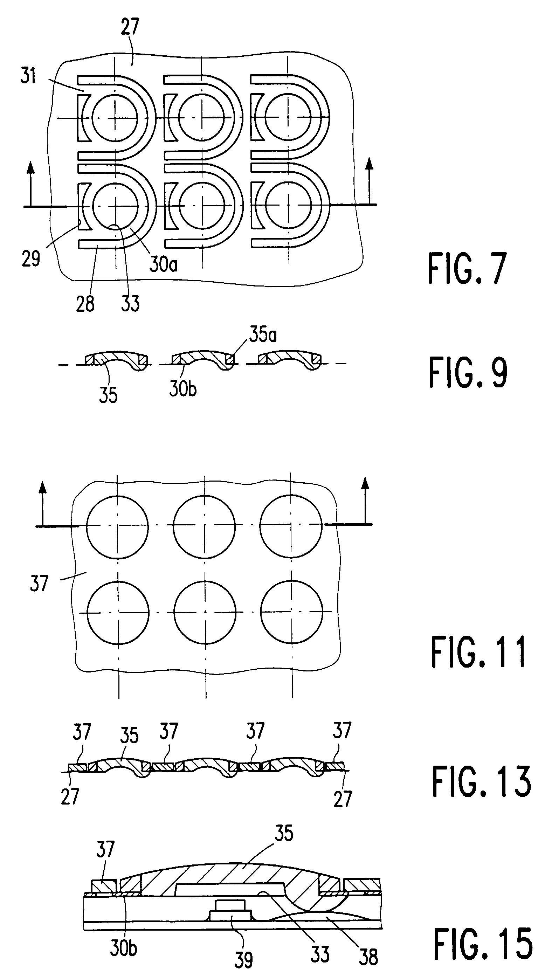

Die vorgefertigten Blechformteile 27 gemäß Fig. 6 und 7 sind Grundgerüst sowohl für eine Gehäuseschale als auch für die Tastatur. Fig. 6 und 7 zeigen durch Spalte 28 und 29 gebildete Zungen 30a, b, die über federnde Stege 31 mit den Blechformteilen 27 verbunden sind. Zusätzliche Öffnungen 32, 33 dienen dazu, den Thermoplastwerkstoff durch Umspritzen dieser Öffnungen festzulegen.

Fig. 8 und 9 zeigen Schnittdarstellungen gemäß Fig. 6 und 7, jedoch zusätzlich mit aufgespritztem Thermoplastwerkstoff 34, 35. Gemäß Fig. 8 durchdringt der Werkstoff 34 die Öffnungen 32 und dient zur Befestigung. Auch der Werkstoff 35 gemäß Fig. 9 durchdringt die größeren Öffnungen 33, ist jedoch aus durchscheinendem Werkstoff hergestellt, so daß eine unterhalb der Tasten angeordnete Lichtquelle zur Beleuchtung der Tasten dienen kann. Im Randbereich der Tasten kann der Werkstoff 35a dunkel gefärbt sein.

Gemäß Fig. 10 und 12 ist zwischen den die Tasten bildenden beschichteten Zungen 30a eine metallische Abdeckplatte 36 vorgesehen, die die Zwischenräume weitgehend gegen elektromagnetische Strahlung abschirmt.

Gemäß Fig. 11 und 13 besteht diese Abdeckplatte 37 aus einem Kunststoff, der aus dem gleichen Werkstoff bestehen kann, aus dem auch die Außenhaut des Gehäuses gebildet ist.

Fig. 14 und 15 zeigen jeweils einen integrierten Tastensatz gemäß der Erfindung zusammen mit der zugehörigen Gehäuseschale über einer Schalteranordnung, die z.B. einen Schnappscheiben-Mechanismus 38 aufweist. Fig. 14 entspricht dabei einer Bauart gemäß Fig. 6, 8, 10, 12, und Fig. 15 entspricht einer Bauart gemäß Fig. 7, 9, 11, 13. Bei der letztgenannten Bauart ist unterhalb der Taste eine Lichtquelle 39 angeordnet.

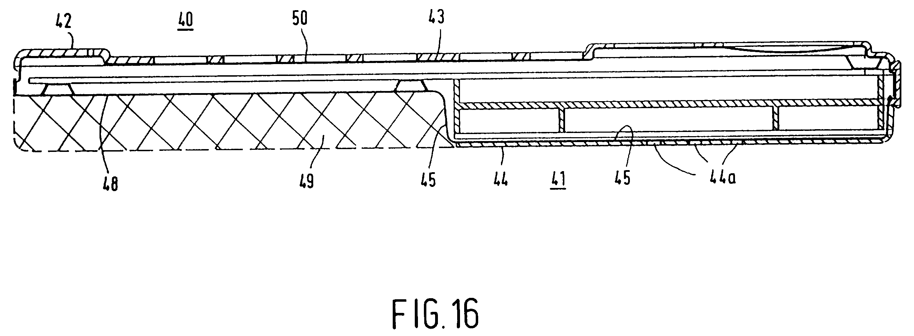

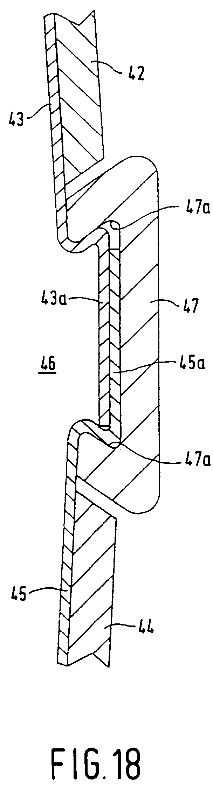

Das Gehäuse gemäß Fig. 16 bis 19 besteht aus einer oberen Gehäuseschale 40 und einer unteren Gehäuseschale 41, die zu einem vollständigen Gehäuse zusammengesetzt sind. Die obere Gehäuseschale 40 besitzt eine aus Thermoplast bestehende Gehäuseaußenhaut 42 und ein innenliegendes Blechformteil 43. Die untere Gehäuseschale 41 besitzt eine außenliegende, aus Thermoplast bestehende Gehäuseaußenhaut 44 und ein innenliegendes Blechformteil 45. Die Gehäuseaußenhaut 42 bzw. 44 wurde in einem Spritzgußverfahren jeweils auf das vorgeprägte Blechformteil 43, 45 aufgespritzt. Die Blechformteile 43, 45 überlappen sich im Bereich der Fügekante mit ihren Enden, wie aus den Stirnbereichen gemäß Fig. 16 oder deutlicher aus Fig. 18 zu erkennen ist. Die Überlappung bewirkt eine Kontaktierung zur Herstellung einer zuverlässigen HF-Dichtung. Damit die einander überlappenden Bereiche 43a und 45a zwecks Herstellung einer guten Kontaktierung fest miteinander verbunden sind, sind beide Teile so abgebogen, daß sie in zusammengesetztem Zustand einen schwalbenschwanzförmigen Vorsprung 46 bilden. Beide Teile sind durch ein Schließelement 47 zusammengehalten, das mit hinterschnittenen Nuten 47a den schwalbenschwanzförmigen Vorsprung 46 umgreift. Dieses Schließelement 47 ist U-förmig ausgebildet und erstreckt sich in Fig. 16 einerseits über die rechte Stirnkante und andererseits über die beiden Seitenkanten des Gehäuses 40, 41. Die Unterschale 41 gemäß Fig. 16 ist mit einem Rücksprung 48 zur Aufnahme eines Akkus 49 versehen. Dieser Akku 49 ist im Bereich des aufzuschiebenden Schließelementes 47 ebenfalls mit einem nicht dargestellten, schwalbenschwanzförmigen Vorsprung versehen, auf den sich das U-förmige Schließelement 47 mit seinen beiden Seitenschenkeln aufschiebt.

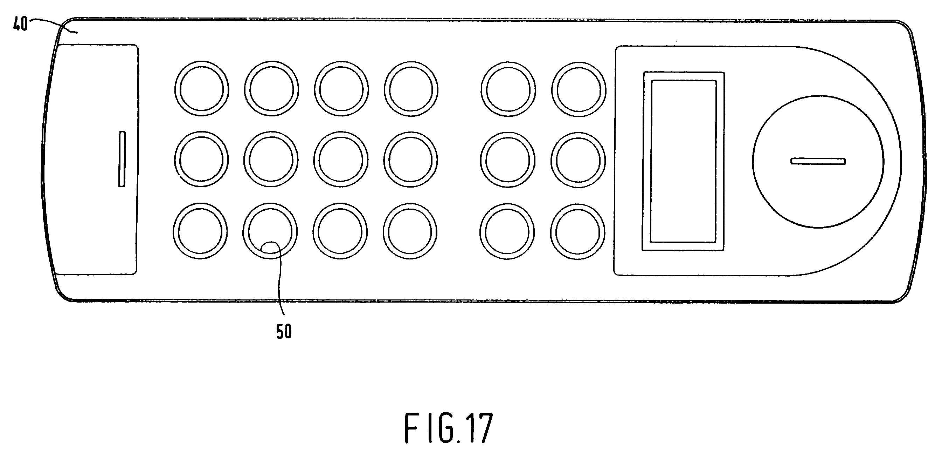

Aus Fig. 16 und 17 ist zu erkennen, daß bei dieser Bauart das Blechformteil 43 der Gehäuseoberschale 40 Aussparungen 50 zur Aufnahme von nicht näher dargestellten Tasten aufweist.

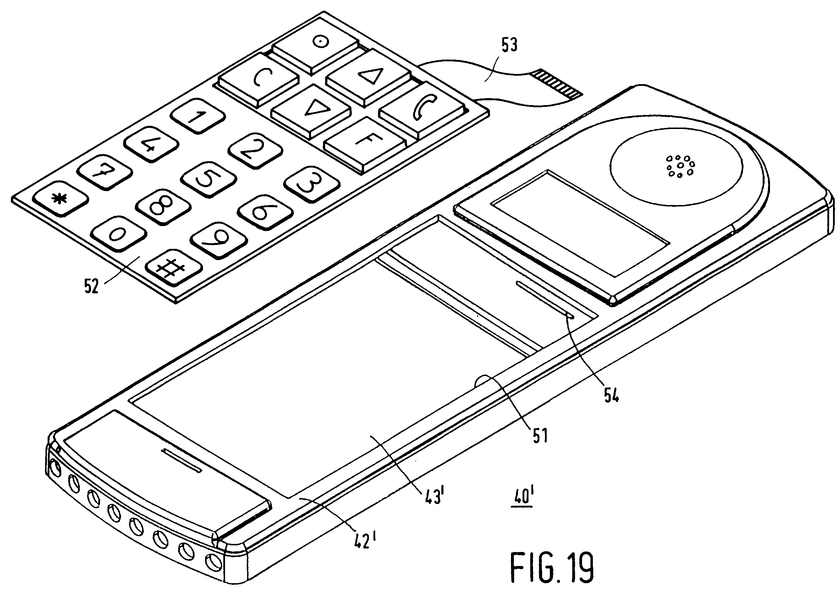

Fig. 19 zeigt in einem weiteren Ausführungsbeispiel eine obere Gehäuseschale 40' mit einem Blechformteil 43', das im Bereich des Tastenfeldes eine durchgehende Fläche aufweist, die also nicht mit Durchbrüchen versehen ist. Im Bereich des Tastenfeldes ist vielmehr die aus Thermoplast bestehende Gehäuseaußenhaut 42' mit einer Aussparung 51 versehen, in die eine oberhalb der Gehäuseschale 40' dargestellte Tastaturschaltfolie 52 eingesetzt und durch Kleben gehalten wird. Die zugehörigen elektrischen Verbindungen 53 in Form eines Flachkabels werden durch einen Spalt 54 in das Gehäuseinnere geleitet.

## Patentansprüche

1. Gehäuse für Geräte der elektrischen Nachrichtentechnik, z.B. Telefongehäuse, bestehend aus zwei Halbschalen (10, 11) mit jeweils einem innenseitigen Blechformteil (13, 15), das mit einer die Gehäuseaußenhaut bildenden aufgespritzten Thermoplastschicht (12, 14) fest verbunden ist.

2. Gehäuse nach Anspruch 1, dadurch gekennzeichnet, daß das Blechformteil (13, 15) und die aus Thermoplast gebildete Gehäuseaußenhaut (12, 14) durch Umspritzen an Kanten oder dergl. oder durch besondere Befestigungselemente (24) miteinander verbunden sind.

3. Gehäuse nach Anspruch 1 oder 2, dadurch gekennzeichnet, daß das Blechformteil (27) im Bereich von Tasten (30a und 34) bewegliche Zungen (30a, b) aufweist, die über mindetsens einen federnden Steg (31) einseitig mit dem Blechformteil (27) verbunden und von der Thermoplastschicht (34, 35) überzogen sind.

4. Gehäuse nach Anspruch 3, dadurch gekennzeichnet, daß die Zungen (30a, b) jeweils durch einen etwa halbkreisförmigen Spalt (28) gebildet sind.

5. Gehäuse nach Anspruch 4, dadurch gekennzeichnet, daß die Zungen (30b) mit einer Mittenöffnung (33) versehen sind und daß die Thermoplastschicht (35) im Bereich der Mittenöffnung (33) aus durchscheinendem Werkstoff besteht.

6. Gehäuse nach einem der Ansprüche 1 bis 5, welches aus zwei Gehäuseschalen (40, 41) mit innenliegenden Blechformteilen (43, 45) gebildet ist, dadurch gekennzeichnet, daß die einander überlappenden Enden (43a, 45a) der beiden Blechformteile (43, 45) einen im Querschnitt schalbenschwanzförmigen Vorsprung (46) bilden und durch mindestens ein den Vorsprung (46) übergreifendes Schließelement (47) zusammengehalten werden.

7. Gehäuse nach Anspruch 6, gekennzeichnet durch ein einziges, U-förmiges Schließelement (47), das in montiertem Zustand eine stirnseitige Kante und mindestens Teile der beiden Seitenkanten des Gehäuses (40, 41) umfaßt.

8. Gehäuse nach einem der Ansprüche 6 oder 7, dadurch gekennzeichnet, daß das Blechformteil (43') der oberen Gehäuseschale (40') im Bereich der Tastatur als geschlossene Fläche ausgebildet ist, auf welcher eine Tastaturschaltfolie (52) angeordnet, z.B. geklebt ist, deren elektrische Verbindungsleitungen (53) durch eine einzige Öffnung 54) in das Gehäuseinnere geführt sind.

9. Verfahren zur Herstellung eines Gehäuses nach Anspruch 1 oder 2, mit folgenden Verfahrensschritten:
a) das Blechformteil (13, 15) wird in einem Tiefziehwerkzeug (25) entsprechend der gewünschten Form geprägt,
b) das vorgefertigte Blechformteil (13, 15) wird in ein Spritzgußwerkzeug (26) eingelegt, das entsprechend der gewünschten Außenkontur des Gehäuses ausgebildet ist,
c) das eingelegte Blechformteil (13, 15) wird, unter Freilassung von auf dem Blechformteil (13, 15) vorgesehenen Durchbrüchen (16, 17), entsprechend der gewünschten Außenkontur des Gehäuses mit Thermoplast (12, 14) umspritzt.

10. Verfahren nach Anspruch 9, dadurch gekennzeichnet, daß das Blechformteil (13, 15) vor dem Umspritzen an der Innenseite im Bereich von Aussparungen (18) mit Funktionselementen (19, 20, 21) versehen wird und daß die Funktionselemente (19, 20, 21) beim Spritzgußvorgang durch das durch die Aussparungen (18) durchtretende Spritzgut mit der Außenhaut (12, 14) verbunden werden.

11. Verfahren nach Anspruch 9 oder 10, dadurch gekennzeichnet, daß das Blechformteil (13, 15) mit zusätzlichen Öffnungen (23) versehen wird und daß das beim Spritzgußvorgang durch diese Öffnungen (23) durchtretende Spritzgut zusätzliche Verbindungselemente (24) zwischen dem Blechformteil (13, 15) und der Außenhaut (12, 14) bildet.

## Claims

1. A housing for appliances used in the field of electrical datacommunication, for example telephone housings, formed by two half shells (10, 11) each with an interior part shaped from metal plating (13, 15) which is fixedly connected to a layer of thermoplastic material (12, 14) injection-moulded thereto which forms the outer shell of the housing.

2. A housing as claimed in Claim 1, characterized in that the part shaped from metal plating (13, 15) and the outer shell (12, 14) of the housing made from thermoplastic material are fixedly connected to one another by injection moulding around edges or the like, or by means of special fastening elements (24).

3. A housing as claimed in Claim 1 or 2, characterized in that the part (27) shaped from metal plating has movable tongues (30a, b) in the region of keys (30a, 34), which tongues are each connected at one side to said metal part (27) by means of at least one resilient bridge (31) and are covered by the layer of thermoplastic material (34, 35).

4. A housing as claimed in Claim 3, characterized in that the tongues (30a, b) are each formed by a substantially semicircular incision (28).

5. A housing as claimed in Claim 4, characterized in that the tongues (30b) are each provided with a central opening (33) and the thermoplastic layer (35) is made of a translucent material in the region of the central opening (33).

6. A housing as claimed in any one of the Claims 1 to 5, formed by two housing shells (40, 41) with parts (43, 45) shaped from metal plating arranged therein, characterized in that the overlapping ends (43a, 45a) of the two parts (43, 45) shaped from metal plating form a projection (46) which is dovetail-shaped in cross-section and are held together by at least one closing element (47) which grips over the projection (46).

7. A housing as claimed in Claim 6, characterized by a single, U-shaped closing element (47) which in the mounted state grips around an extreme edge and at least portions of the two side edges of the housing (40, 41).

8. A housing as claimed in Claim 6 or 7, characterized in that the part (43') shaped from metal plating of the upper housing shell (40') is constructed as an uninterrupted surface in the region of the keyboard, on which surface a keyboard switching foil (52) is provided, for example glued, whose electrical connection lines (53) are passed through a single opening (54) into the housing interior.

9. A method of manufacturing a housing as claimed in Claim 1 or 2, comprising by the following process steps:
a) the metal part (13, 15) is forced into the desired shape in a deep-drawing tool (25),
b) the metal part (13, 15) thus prepared is laid in an injection mould (26) which is formed so as to correspond to the desired outer contours of the housing,
c) the inserted metal part (13, 15) is surrounded with injected thermoplastic material (12, 14), leaving exposed openings (16, 17) provided in the metal part (13, 15), in accordance with the desired outer contours of the housing.

10. A method as claimed in Claim 9, characterized in that the part shaped from metal plating (13, 15) is provided with functional elements (19, 20, 21) at the inside in the region of openings (18) before injection moulding, and said functional elements (19, 20, 21) are connected to the outer shell (12, 14) during the injection moulding process by means of the injected material which passes through the openings (18).

11. A method as claimed in Claim 9 or 10, characterized in that the part shaped from metal plating (13, 15) is provided with additional openings (23) and in that the material passing through these openings (23) during the injection moulding process forms additional connecting elements (24) between the part shaped from metal plating (13, 15) and the outer shell (12, 14).

## Revendications

1. Boîtier pour appareils de télécommunication électrique, par exemple un boîtier de téléphone, composé de deux moitiés (10, 11) avec respectivement une pièce moulée en tôle (13, 15) interne qui est fixée rigidement à une couche thermoplastique (12, 14) injectée formant l'enveloppe externe du boîtier.

2. Boîtier selon la revendication 1, caractérisé en ce que la pièce moulée en tôle (13, 15) et l'enveloppe externe du boîtier formée d'un matériau thermoplastique (12, 14) sont fixées par extrusion sur les bords ou autre ou par des éléments de fixation (24) particuliers.

3. Boîtier selon l'une des revendications 1 ou 2, caractérisé en ce que la pièce moulée en tôle (27) présente dans la zone des touches (30a et 34) des languettes mobiles (30a, b) qui sont fixées par l'intermédiaire d'au moins une nervure élastique (31) unilatéralement à la pièce moulée en tôle (27) et qui sont recouvertes par la couche thermoplastique (34, 35).

4. Boîtier selon la revendication 3, caractérisé en ce que les languettes (30a, b) sont formées respectivement par une fente (28) de forme approximativement hémisphérique.

5. Boîtier selon la revendication 4, caractérisé en ce que les languettes (30b) sont dotées d'une ouverture centrale (33) et que la couche thermoplastique (35) dans la zone de l'ouverture centrale (33) se compose d'un matériau transparent.

6. Boîtier selon l'une des revendications 1 à 5, qui se compose de deux moitiés de boîtier (40, 41) avec des pièces moulées en tôle (43, 45) internes, caractérisé en ce que les extrémités (43a, 45a) des deux pièces moulées en tôle (43, 45) qui se chevauchent, forment une saillie (46) en forme de queue-d'aronde en coupe transversale et sont maintenues par au moins un élément de fermeture (47) qui saisit par le haut la saillie (46).

7. Boîtier selon la revendication 6, caractérisé par un élément de fermeture (47) unique en forme de U qui comprend à l'état monté un bord en face d'about et au moins des parties des deux bords latéraux du boîtier (40, 41).

8. Boîtier selon l'une des revendications 6 ou 7, caractérisé en ce que la pièce moulée en tôle (43') de la moitié supérieure du boîtier (40') est conçue dans la zone du clavier comme une surface fermée sur laquelle une feuille de commutation de clavier (52) est disposée ou par exemple collée et dont les câbles de connexion électrique (53) sont guidés par une ouverture unique (54) à l'intérieur du boîtier.

9. Procédé de fabrication d'un boîtier selon l'une des revendications 1 ou 2 avec les étapes de procédé suivantes :
a) la pièce moulée en tôle (13, 15) est moulée dans un outil d'emboutissage (25) en fonction de la forme souhaitée,
b) la pièce moulée en tôle préfabriquée (13, 15) est introduite dans un outil de coulage par injection (26) qui est conçu en fonction du contour externe souhaité du boîtier,
c) la pièce moulée en tôle insérée (13, 15) est extrudée en fonction du contour externe souhaité du boîtier avec un matériau thermoplastique (12, 14) en libérant les orifices traversants (16, 17) prévus sur la pièce moulée en tôle (13, 15).

10. Procédé selon la revendication 9, caractérisé en ce que la pièce moulée en tôle (13, 15) est dotée d'éléments fonctionnels (19, 20, 21) avant l'extrusion sur sa face interne dans la zone des évidements (18) et que ces éléments fonctionnels (19, 20, 21) sont reliés à l'enveloppe externe (12, 14) lors de l'opération de coulage par injection par le matériau injecté pénétrant au travers des évidements (18) à l'enveloppe externe.

11. Procédé selon l'une des revendications 9 ou 10, caractérisé en ce que la pièce moulée en tôle (13, 15) est dotée d'ouvertures supplémentaires (23) et que, lors de l'opération de coulage par injection, le matériau injecté traversant ces ouvertures (23) forme des éléments de fixation supplémentaires (24) entre la pièce moulée en tôle (13, 15) et l'enveloppe extérieure (12, 14).
